# EUROPEAN PATENT APPLICATION

(11) **EP 2 503 549 A1**
(43) Date of publication of application: **26.09.2012**
(21) Application number: 10831586.2
(22) Date of filing: 17.11.2010
(51) Int. Cl.: G11B 5/738, C23C 14/14, C23C 14/34

(54) **AG ALLOY THERMAL DIFFUSION CONTROL FILM USED IN MAGNETIC RECORDING MEDIUM FOR THERMALLY ASSISTED RECORDING, MAGNETIC RECORDING MEDIUM FOR THERMALLY ASSISTED RECORDING, AND SPUTTERING TARGET**

(30) Priority: 18.11.2009 JP 2009262908
(71) Applicant: Kabushiki Kaisha Kobe Seiko Sho, Kobe-shi, Hyogo 651-8585 (JP)
(72) Inventor: NAKAI Junichi, Kobe-shi Hyogo 651-2271 (JP); TAUCHI, Yuki, Kobe-shi Hyogo 651-2271 (JP)
(74) Representative: Müller-Boré & Partner Patentanwälte
(86) International application number: PCT/JP2010/070486
(87) International publication number: WO 2011/062192

(57) **Abstract**

Disclosed is a thermal diffusion control film to be used in a magnetic medium for thermally assisted recording, said thermal diffusion control film maintaining a high heat conductivity, and at the same time, having all of a high thermal diffusivity, a smooth surface roughness, and a high heat resistance. The thermal diffusion control film, i.e., an Ag alloy thermal diffusion control film, is composed of an Ag alloy having Ag as a main component, and satisfies a surface roughness (Ra) of 1.0 nm or less, a heat conductivity of 100 W/(m·K) or more, and a thermal diffusivity of 4.0 x 10⁻⁵ m²/s or more.

## Description

### Technical Field

The present invention relates to a Ag alloy thin film that is useful as a thermal diffusion control film disposed between a substrate and a recording film or an underlying layer in a magnetic recording medium for use in hard disk drives for heat-assisted magnetic recording (HAMR), in which magnetic recording is assisted through local heating with a laser beam or near-field light in a recording process, and a magnetic recording medium that includes the Ag alloy thin film.

### Background Art

With the recent increasing demand for magnetic recording media having a high storage capacity, the surface recording density of magnetic recording media has been increased. With an increase in the recording density of a magnetic recording medium, the volume of the magnetic recording medium per bit decreases. This causes a problem of recording demagnetization due to thermal disturbance.

In order to address such a problem, for example, a change in recording method from horizontal recording to vertical recording and a change in the structure of a recording layer have been proposed. However, these are not ultimate solutions. The recording demagnetization due to thermal disturbance increases in accordance with exp(vKu/kT) wherein Ku denotes the magnetocrystalline anisotropy constant of a magnetic recording material, v denotes the volume of the magnetic recording medium per bit, k denotes the Boltzmann constant, and T denotes the absolute temperature. Thus, a decrease in volume per bit (v) resulting from an increase in recording density must be compensated for by an increase in Ku. However, Ku is intrinsic to a material, and a common soft magnetic recording material CoCrPt has a low Ku and cannot satisfy the requirement.

Thus, in order to provide a material having high magnetocrystalline anisotropy, ordered alloys, such as CoPt and FePt, are being investigated. However, such a material having high magnetocrystalline anisotropy cannot be used in the magnetic fields applicable to existing recording heads.

Since the magnetocrystalline anisotropy of a recording material decreases with increasing temperature, heat-assisted magnetic recording is proposed in which a target area is heated with a laser beam or near-field light only during recording. The heat-assisted magnetic recording is an integrated recording method of a magnetic recording technique and an optical recording technique. In a high-retentivity medium that cannot be used in general magnetic recording, after recording is performed while the retentivity of a recording magnetic portion is locally decreased by means of laser irradiation heating, the medium is quenched to room temperature to increase retentivity during storage.

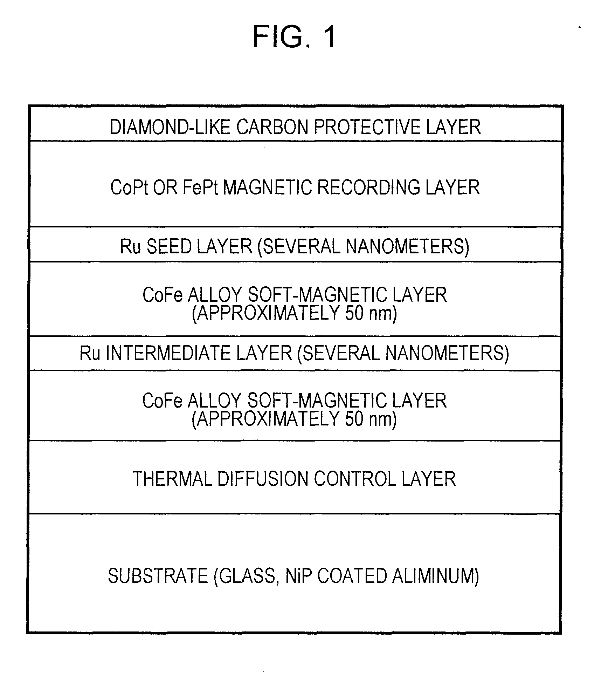

In the heat-assisted magnetic recording, it is desirable that the medium be rapidly cooled after heating in the recording process. Thus, in order to promote thermal diffusion, a thermal diffusion control film having high thermal conductivity is disposed between a substrate and an underlying layer or a recording film. Fig. 1 illustrates the structure of a heat-assisted magnetic recording medium that includes a thermal diffusion control film according to one embodiment.

For example, Patent Literatures 1 and 2 describe such a heat-assisted magnetic recording medium. These literatures disclose, as a thermal diffusion control film, a heat sink layer containing Cu, Ag, Au, W, Si, or Mo (Patent Literature 1) and a heat control layer containing Al, Ni, Au, Ag, Cu, Rh, Pt, or Ru as a mother element and Al, Ni, Au, Ag, Cu, Rh, Pt, Pd, Ti, Ta, Nb, Cr, Zr, or V as an additional element (Patent Literature 2).

### Citation List

### Patent Literature

PTL 1: Japanese Unexamined Patent Application Publication No. 2008-210426
PTL 2: Japanese Unexamined Patent Application Publication No. 2008-34078

### Summary of Invention

### Technical Problem

Among these, Au, Cu, or Ag has a high thermal conductivity (data for bulk) of approximately 317, 401, or 429 W/(m·K), respectively, in accordance with Rikagaku Jiten (physical and chemical dictionary), and is therefore suitable for a thermal diffusion control film. However, the temperature in heat-assisted magnetic recording should be rapidly increased during writing with laser irradiation and rapidly decreased after the laser is turned off. Thus, as well as high thermal conductivity, high thermal diffusivity is important. Au, Cu, or Ag has a thermal diffusivity of 1.3 x 10⁻⁴, 1.2 x 10⁻⁴, or 1.8 x 10⁻⁴ m²/s, respectively. Ag has the highest thermal diffusivity. With respect to the elements other than Ag, Au has very high corrosion resistance but is very expensive, and is not industrially suitable in terms of cost. Cu is more easily oxidized than Ag or Au and is inferior in corrosion resistance. In contrast, Ag has the highest thermal diffusivity and excellent thermal properties, as described above, is highly resistant to oxidative corrosion, as is clear from being categorized into noble metal, and has low reactivity to other metals. Thus, Ag is the most suitable for a thermal diffusion control layer.

However, a Ag thin film generally has a high surface roughness Ra of several nanometers or more and easily undergoes a change in its structure, such as grain growth or surface roughening, by heating. Since the distance between a magnetic head and a magnetic recording medium is very small, the magnetic recording medium should have a very smooth surface, for example, having an Ra of approximately 1.0 nm or less. Thus, in accordance with one consideration, the thickness of a Ag thin film is decreased to approximately 20 nm or less to reduce an increase in Ra. However, this causes deterioration of heat capacity or the thermal diffusion effect, resulting in marked deterioration of the functions of the thermal diffusion control layer. Furthermore, in the heat-assisted magnetic recording, repeated exposure to high-temperature heating of more than 100°C and rapid cooling to room temperature requires high heat resistance.

As described above, a thermal diffusion control film for use in a magnetic recording medium for heat-assisted magnetic recording should have high thermal conductivity, thermal diffusivity, surface smoothness, and heat resistance. A thin film made of Ag alone cannot satisfy these requirements.

In view of the situations described above, it is an object of the present invention to provide a Ag alloy thermal diffusion control film for use in a heat-assisted magnetic recording medium. The Ag alloy thermal diffusion control film has high thermal conductivity, high thermal diffusivity, low surface roughness, and high heat resistance. The present invention also provides a magnetic recording medium that includes the Ag alloy thermal diffusion control film and a sputtering target useful for the manufacture of the Ag alloy thermal diffusion control film.

### Solution to Problem

The present invention includes the following aspects.
(1) A Ag alloy thermal diffusion control film for use in a magnetic recording medium for heat-assisted magnetic recording, wherein the thermal diffusion control film contains a Ag alloy mainly composed of Ag and has a surface roughness Ra of 1.0 nm or less, a thermal conductivity of 100 W/(m·K) or more, and a thermal diffusivity of 4.0 x 10⁻⁵ m²/s or more.
(2) The Ag alloy thermal diffusion control film according to (1), wherein the Ag alloy contains 0.05% to 0.8% by atom of at least one of Nd and Y and 0.05% to 0.5% by atom of Bi.
(3) The Ag alloy thermal diffusion control film according to (2), wherein the Ag alloy further contains 0.2% to 1.0% by atom of Cu.
(4) A magnetic recording medium for heat-assisted magnetic recording, including the Ag alloy thermal diffusion control film according to any one of (1) to (3).
(5) A sputtering target for use in the manufacture of the Ag alloy thermal diffusion control film according to any one of (1) to (3), wherein the sputtering target is made of a Ag alloy that contains 0.05% to 0.8% by atom of at least one of Nd and Y and 0.05% to 0.5% by atom of Bi.
(6) The sputtering target according to (5), wherein the Ag alloy further contains 0.2% to 1.0% by atom of Cu.

### Advantageous Effects of Invention

The present invention can provide a Ag alloy thermal diffusion control film in which the composition of Ag alloy is appropriately controlled to maintain high thermal conductivity of Ag and enhance the thermal diffusivity, surface smoothness, and heat resistance of the Ag alloy thermal diffusion control film. Thus, the thermal diffusion control film can be suitably used in magnetic recording media for heat-assisted magnetic recording.

### Brief Description of Drawings

[Fig. 1] Fig. 1 is an explanatory view of the film structure of a magnetic recording medium for heat-assisted magnetic recording according to one embodiment.
[Fig. 2] Figs. 2(a) to 2(c) are SEM photographs indicating the surface properties of a pure Ag thin film in Example 2. Fig. 2(a) is an as-deposition SEM photograph (magnification: 30000). Fig. 2(b) is an SEM photograph (magnification: 6000) after heat treatment in the air at 400°C for one hour. Fig. 2(c) is an enlarged view of Fig. 2(b) (magnification: 30000).
[Fig. 3] Figs. 3(a) to 3(c) are SEM photographs indicating the surface properties of a Ag alloy thin film (Ag-0.25Nd alloy) in Example 2. Fig. 3(a) is an as-deposition SEM photograph (magnification: 30000). Fig. 3(b) is an SEM photograph (magnification: 6000) after heat treatment in the air at 400°C for one hour. Fig. 3(c) is an enlarged view of Fig. 3(b) (magnification: 30000).
[Fig. 4] Figs. 4(a) to 4(b) are SEM photographs indicating the surface properties of a Ag alloy thin film (Ag-0.07Bi-0.18Nd alloy) in Example 2. Fig. 4(a) is an as-deposition SEM photograph (magnification: 30000). Fig. 4(b) is an SEM photograph (magnification: 30000) after heat treatment in the air at 400°C for one hour.
[Fig. 5] Fig. 5 is a graph showing the effect of Ar gas pressure during deposition on the surface roughness Ra of a Ag alloy thin film in Example 3.
[Fig. 6] Fig. 6 is a graph showing the effect of the thickness of a Ag alloy thin film on the surface roughness Ra in Example 3.

### Description of Embodiments

The present inventors made extensive studies so as to provide a Ag alloy thin film that can be suitably used as a thermal diffusion control film for use in a magnetic recording medium for heat-assisted magnetic recording. As a result, the present inventors arrived at the present invention by finding that use of a Ag alloy that contains predetermined amounts of Nd and/or Y as well as Bi and preferably further contains a predetermined amount of Cu can achieve the intended objects.

A thermal diffusion control film according to the present invention contains a Ag alloy mainly composed of Ag and has a surface roughness Ra of 1.0 nm or less, a thermal conductivity of 100 W/(m·K) or more, and a thermal diffusivity of 4.0 x 10⁻⁵ m²/s or more. As described above, a thermal diffusion control film for use in a magnetic recording medium for heat-assisted magnetic recording is required to have high thermal conductivity, thermal diffusivity, surface smoothness, and heat resistance. The present invention can provide a Ag alloy film that satisfies all the requirements.

The phrase "Ag alloy mainly composed of Ag", as used herein, refers to an alloy in which Ag constitutes the highest percentage, generally 50% by atom or more (preferably 70% by atom or more) and less than 100% by atom, of the alloy.

Among the requirements, the thermal conductivity and the thermal diffusivity were determined by the following reasons.

In general, the thermal conductivity and the thermal diffusivity decrease with increasing amounts of alloying elements. For example, in the magnetic recording medium for heat-assisted magnetic recording illustrated in Fig. 1, the above-mentioned characteristics of a CoFe alloy film serving as a soft-magnetic layer have not been studied in detail. In view of the tendency described above, the thermal conductivity and the thermal diffusivity of CoFe calculated with the values of pure Co taken into account are approximately 0.23 and 0.15 times those of pure Ag, respectively, and are much lower than the thermal conductivity and the thermal diffusivity of pure Ag (see Table 1). The thermal diffusivity is defined by thermal diffusivity = thermal conductivity/(specific heat x density). In general, since the specific heat and the density are independent of alloying, the thermal diffusivity depends only on the thermal conductivity.

The values described above were determines as described below. First, the thermal conductivity, specific heat, and density of pure Co were taken from literatures, such as Rikagaku Jiten (physical and chemical dictionary). The thermal conductivities of pure Ag and Ag alloy thin films are difficult to measure and are therefore calculated from their electrical conductivities in accordance with the theoretical formula. In general, the thermal conductivity of a thin film is lower than the thermal conductivity of an ingot because of defects or grain boundaries. In the case of pure Ag, the thermal conductivity is 429 W/(m·K) for an ingot and 314 W/(m·K) for a thin film (see No. 1 in Table 2 below). The density and the specific heat of a thin film of pure Ag were considered to be equal to the density and the specific heat of an ingot of pure Ag. For reference, Table 1 shows the thermal conductivity and the thermal diffusivity of Al, Cu, Co, Au, and Ag.

**[Table 1]**

| | Thermal conductivity | | Thermal diffusivity | |
|---|---|---|---|---|
| | W/(m·K) | Relative to pure Ag ingot | m²/sec | Relative to pure Ag thin film |
| Al | 238 | 0.55 | 9.8E-05 | 0.56 |
| Cu | 401 | 0.93 | 1.2E-04 | 0.68 |
| Co | 100 | 0.23 | 2.7E-05 | 0.15 |
| Au | 317 | 0.74 | 1.3E-04 | 0.73 |
| Ag | 429 | 1.00 | 1.8E-04 | 1.00 |

| | | | | |
|---|---|---|---|---|
| * "E-0X" in the table means "10^{-x}". | | | | |

A thermal diffusion control film for heat-assisted magnetic recording should have higher thermal conductivity and thermal diffusivity than general-purpose CoFe films. Thus, in consideration of the values described above, the present invention is considered to be effective when the thermal conductivity and the thermal diffusivity of a Ag thin film alloy are approximately 0.5 or more times those of a pure Ag thin film, that is, 100 W/(m·K) or more and 4.0 x 10⁻⁵ m²/s or more, respectively. Preferably, the thermal conductivity and the thermal diffusivity of the Ag thin film alloy are approximately 0.6 or more times those of the pure Ag thin film and 200 W/(m·K) or more and 8.2 x 10⁻⁵ m²/s or more, respectively.

In the present invention, the surface roughness Ra is 1.0 nm or less. The surface roughness Ra should be as small as possible and is preferably 0.8 nm or less.

More specifically, a Ag alloy for use in the present invention contains 0.05% to 0.8% by atom of Nd and/or Y and 0.05% to 0.5% by atom of Bi and preferably further contains 0.2% to 1.0% by atom of Cu.

### Nd and/or Y: 0.05% to 0.8% by atom

Nd and Y can improve surface smoothness and heat resistance. These elements may be used alone or in combination. Among these, Nd is preferred.

Less than 0.05% by atom of these elements (the amount of element when the element is used alone or the total amount of elements when the elements are used in combination) may have insufficient effects. On the other hand, more than 0.8% by atom of these elements may result in a significant decrease in thermal conductivity and thermal diffusivity. The amount of these elements is preferably 0.1% by atom or more and 0.6% by atom or less, more preferably 0.1% by atom or more and 0.5% by atom or less. These upper limits and lower limits of the amount of these elements may be appropriately combined to define the amount of these elements.

### Bi: 0.05% to 0.5% by atom

Like Nd, Bi can improve surface smoothness and heat resistance. More specifically, Bi cannot improve surface smoothness as much as Nd or Y but can improve heat resistance more than Nd or Y. Less than 0.05% by atom of Bi may have insufficient effects, and more than 0.5% by atom of Bi may result in a significant decrease in thermal conductivity and thermal diffusivity. The Bi content is preferably 0.05% by atom or more and 0.4% by atom or less, more preferably 0.05% by atom or more and 0.3% by atom or less. These upper limits and lower limits of the Bi content may be appropriately combined to define the Bi content.

A Ag alloy according to one aspect of the present invention contains Nd and/or Y as well as Bi and the remainder of Ag and incidental impurities. A Ag alloy according to another aspect of the present invention contains Nd and/or Y as well as Bi, 0.2% to 1.0% by atom of Cu described below so as to further improve its characteristics, and the remainder of Ag and incidental impurities.

Examples of the incidental impurities include N, O, C, Fe, and Si. The amount of incidental impurities is generally 0.01% by weight or less.

### Cu: 0.2% to 1.0% by atom

Cu can decrease the crystal grain size of a Ag alloy thin film and improve surface smoothness. Less than 0.2% by atom of Cu may have insufficient effects, and more than 1.0% by atom of Cu may result in a significant decrease in thermal conductivity and thermal diffusivity. The Cu content is preferably 0.4% by atom or more and 1.0% by atom or less, more preferably 0.5% by atom or more and 0.8% by atom or less. These upper limits and lower limits of the Cu content may be appropriately combined to define the Cu content.

The relationship between the elements for use in the present invention and surface roughness (Ra of 1.0 nm or less) will be described in detail below.

In general, the surface smoothness of a thin film substantially depends on the crystal grain size; a decrease in crystal grain size results in a smoother surface. Among Ag alloys for use in the present invention, in the case of a Ag-Nd alloy containing Nd, since Nd has an atomic radius approximately 1.3 times as large as Ag, a supersaturated solid solution formed in sputter deposition has a very large lattice strain. As described above, crystal grains are likely to grow in the sputter deposition of a pure Ag film. In the Ag-Nd alloy, however, the lattice strain decreases the crystal grain size of the Ag-Nd alloy thin film, thus providing excellent surface smoothness. The large lattice strain prevents crystal grain growth during heating, thus providing excellent surface smoothness even after heat treatment.

An increase in surface roughness (surface roughening) of a Ag thin film during heating not only increases the crystal grain size but also causes the diffusion of Ag on the thin film surface because of a decrease in surface tension. Ag is highly resistant to oxidation, as is clear from being categorized into noble metal. Thus, an oxide film is not formed on a Ag thin film surface, making it difficult to prevent the surface diffusion of Ag.

Nd added in the present invention is dispersed in Ag crystal grains to prevent grain growth but is not effective in preventing the surface diffusion of Ag. This is true for Y.

Bi is very effective in preventing the surface diffusion of Ag. Bi dose not dissolve in Ag and diffuses on a Ag film surface during sputter deposition because of its very fast diffusion, forming a barrier layer of Bi oxide. The Bi oxide barrier layer can prevent the surface diffusion of Ag and probably maintain excellent surface smoothness even during heating. Unlike Nd or Y, Bi causes strain within Ag crystal grains and is little effective in preventing the crystal grain growth.

The combined use of Nd and/or Y and Bi according to a preferred aspect of the present invention results in a combination of the grain growth inhibiting effect of Nd and/or Y and the surface diffusion inhibiting effect of Bi, thereby probably preventing deterioration in the surface smoothness of the Ag alloy film during heat treatment.

Cu used as a preferred optional component in the present invention does not cause strain in Ag crystal grains and is not unevenly distributed on the Ag thin film surface. However, because of its higher melting point than Ag, Cu forms a nucleation site early in sputter deposition and is effective in decreasing the Ag crystal grain size. Cu does not improve heat resistance but does not significantly decrease thermal conductivity or thermal diffusivity for the amount of Cu added. Thus, Cu can preferably be added to Nd and/or Y and Bi so as to decrease the crystal grain size in an early stage. Although Pd and Au have the same effects as Cu, Pd and Au decrease thermal conductivity more significantly than Cu and are more expensive than Cu. Thus, Cu is employed as a preferred optional component in the present invention.

The thickness of a Ag alloy thermal diffusion control film according to the present invention is such that Ra can be controlled to 1.0 nm or less. More specifically, the thickness of a Ag alloy thermal diffusion control film according to the present invention is preferably approximately 270 nm or less, more preferably 200 nm or less, and preferably 10 nm or more, more preferably 50 nm or more.

The Ag alloy film is more preferably formed by a sputtering process using a sputtering target (hereinafter also referred to as a "target"). The sputtering process can easily form a thin film that has higher in-plane uniformity with respect to component and film thickness than a thin film formed by an ion plating process or an electron-beam evaporation process.

In the formation of the Ag alloy film by the sputtering process, a Ag alloy sputtering target that contains the elements described above (Nd and/or Y, Bi, and preferably Cu) and has the same composition as a desired Ag alloy film may be used to form a Ag alloy film having a desired composition without variations in composition.

Thus, a sputtering target that has the same composition as the Ag alloy film is within the scope of the present invention. More specifically, the target contains 0.05% to 0.8% by atom of Nd and/or Y, 0.05% to 0.5% by atom of Bi, and the remainder of Ag and incidental impurities. A preferred target contains 0.05% to 0.8% by atom of Nd and/or Y, 0.05% to 0.5% by atom of Bi, 0.2% to 1.0% by atom of Cu, and the remainder of Ag and incidental impurities.

The target may assume any shape (a square plate, a circular plate, or a toroidal plate) depending on the shape or structure of a sputtering apparatus.

The target may be manufactured by a casting process, a powder sintering process, or a spray forming process.

The Ar gas pressure in sputtering may be such that Ra can be controlled to 1.0 nm or less. More specifically, the Ar gas pressure is preferably approximately 6 mTorr or less, more preferably 5 mTorr or less, and preferably 0.5 mTorr or more, more preferably 1 mTorr or more.

Thus, a Ag alloy thermal diffusion control film according to the present invention can be suitably used in magnetic recording media for heat-assisted magnetic recording. The magnetic recording media for heat-assisted magnetic recording may have any common film structure. Representatively, the magnetic recording media have a layered structure that includes a thermal diffusion control film, at least one underlying layer, at least one magnetic recording layer, and at least one protective layer, on a substrate. The thermal diffusion control film may be disposed between a substrate and an underlying layer or a magnetic recording layer. Fig. 1 illustrates an example of a magnetic recording medium for heat-assisted magnetic recording in which a Ag alloy thermal diffusion control film according to the present invention can be used. The present invention is not limited to this example.

### EXAMPLES

Although the present invention is more specifically described in the following examples, the present invention is not limited to these examples. Various modifications may be made to these examples without departing from the gist described above and below. These modifications are also within the technical scope of the present invention.

### EXAMPLE 1

In the present example, the effects of the composition of a Ag alloy thin film on thermal conductivity, thermal diffusivity, and surface smoothness (Ra) were studied.

More specifically, various Ag alloy thin films each having a thickness of 200 nm listed in Table 2 were formed on a glass substrate (Corning #1737, substrate size: diameter 50 mm, thickness 1 mm) by DC magnetron sputtering. The deposition conditions included a substrate temperature of 22°C, an Ar gas pressure of 2 mTorr, an input electric power density of 0.025 W/cm², and a back pressure of <5 x 10⁻⁶ Torr.

The amounts of the elements of the Ag alloy were determined from a sample having a film thickness of 100 nm formed on the glass substrate by inductively coupled plasma emission spectrometry (ICP emission spectrometry).

The thermal conductivity, thermal diffusivity, and surface smoothness (Ra) of the Ag alloy thin film thus prepared were examined as described below.

### Measurement of Thermal Conductivity and Thermal Diffusivity

The thermal conductivity was calculated from the electric resistivity of a thin film measured by a four-terminal method.

The thermal diffusivity was calculated in accordance with thermal diffusivity = thermal conductivity/(specific heat x density). As described above, the density and the specific heat of pure Ag and Ag alloy films are generally the same as those of an ingot of pure Ag. Thus, values in literatures were used (density 8900 kg/m³, specific heat 234 J/(kg·K)).

### Measurement of Surface Roughness Ra

Ra was determined in a 3 µm x 3 µm area using an atomic force microscope (AFM). A thin film immediately after deposition and a thin film after vacuum heat treatment at 200°C for 10 minutes were used in the measurement.

As the overall rating, a film having a thermal conductivity of 200 W/(m·K) or more, a thermal diffusivity of 8.2 x 10⁻⁵ m²/s or more, and a surface roughness Ra of 1.0 nm or less was rated as "A", a film having a thermal conductivity of 100 W/(m·K) or more, a thermal diffusivity of 4.0 x 10⁻⁵ m²/s or more, and a surface roughness Ra of 1.0 nm or less was rated as "B", and the other films were rated as "C".

Table 2 summarizes the results.

**[Table 2]**

| No. | | Thermal conductivity | | Thermal diffusivity | | Surface smoothness: Ra(nm) | | Overall rating |
|---|---|---|---|---|---|---|---|---|
| | | W/(m·K) | Relative to pure Aq thin film | m²/sec | Relative to pure Aq thin film | as-Depo. | 200°C × 10min | |
| 1 | Pure Ag | 314 | 1.00 | 1.8E-04 | 1.00 | 4.2 | 6.3 | C |
| 2 | Ag-0.07Bi-0.1Nd | 210 | 0.67 | 8.6E-05 | 0.67 | 0.7 | 0.7 | A |
| 3 | Aq-0.07Bi-0.2Nd | 185 | 0.59 | 7.5E-05 | 0.59 | 0.6 | 0.7 | B |
| 4 | Ag-0.10Bi-0.05Nd | 240 | 0.76 | 9.8E-05 | 0.76 | 0.7 | 0.8 | A |
| 5 | Ag-0.14Bi-0.05Nd | 241 | 0.77 | 9.8E-05 | 0.77 | 0.7 | 0.8 | A |
| 6 | Aq-0.19Bi-0.05Nd | 177 | 0.56 | 7.2E-05 | 0.56 | 0.8 | 0.8 | B |
| 7 | Ag-0.05Bi-0.4Nd-0.6Cu | 164 | 0.52 | 6.7E-05 | 0.52 | 0.5 | 0.7 | B |
| 8 | Ag-0.05Bi-0.7Nd-0.9Cu | 129 | 0.41 | 5.3E-05 | 0.41 | 0.5 | 0.6 | B |
| 9 | Aq-0.9Pd-1.7Cu | 184 | 0.59 | 7.5E-05 | 0.59 | 1.2 | 2.6 | C |
| 10 | Ag-0.93Pd | 248 | 0.79 | 1.0E-04 | 0.79 | 1.4 | 2.1 | C |
| 11 | Aq-1.6Au | 243 | 0.77 | 9.9E-05 | 0.77 | 1.3 | 2.2 | C |
| 12 | Ag-0.9Au-1.0Cu | 239 | 0.76 | 9.7E-05 | 0.76 | 0.8 | 1.3 | C |

| | | | | | | | | |
|---|---|---|---|---|---|---|---|---|
| * "E-0X" in the table means "10^{-x}". | | | | | | | | |

Table 2 shows that Ag alloys (Nos. 2 to 8), which contained Nd, Bi, and Cu within the scope of the present invention, have high thermal conductivity comparable to pure Ag (No. 1) and much higher thermal diffusivity and surface smoothness than pure Ag. The surface smoothness was excellent not only immediately after deposition but also after heating, indicating high heat resistance.

In contrast, Ag alloys of Nos. 9 to 12, which contained an element not specified by the present invention, had low thermal diffusivity or high Ra.

### EXAMPLE 2

In the present example, various Ag alloy thin films were formed on a glass substrate, and the surface profiles after deposition and after heat treatment were observed with a scanning reflection electron microscope (SEM).

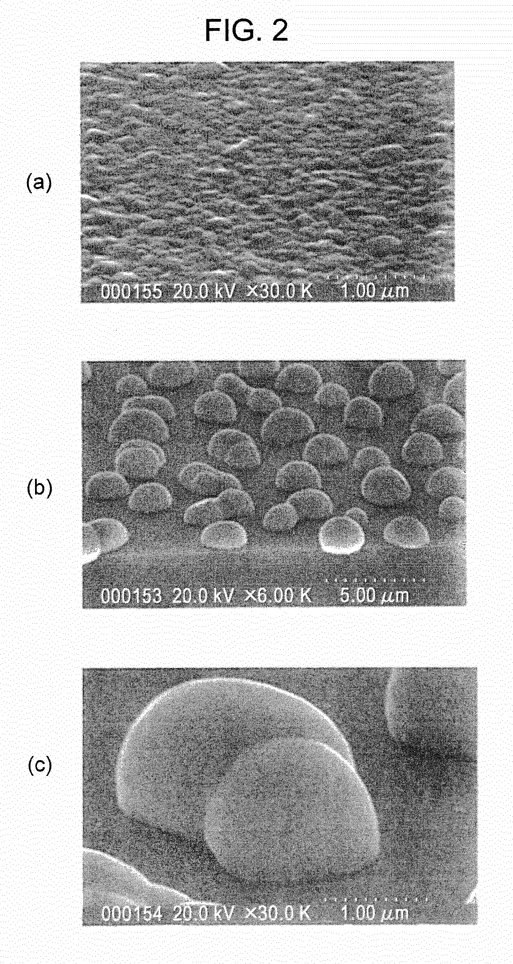

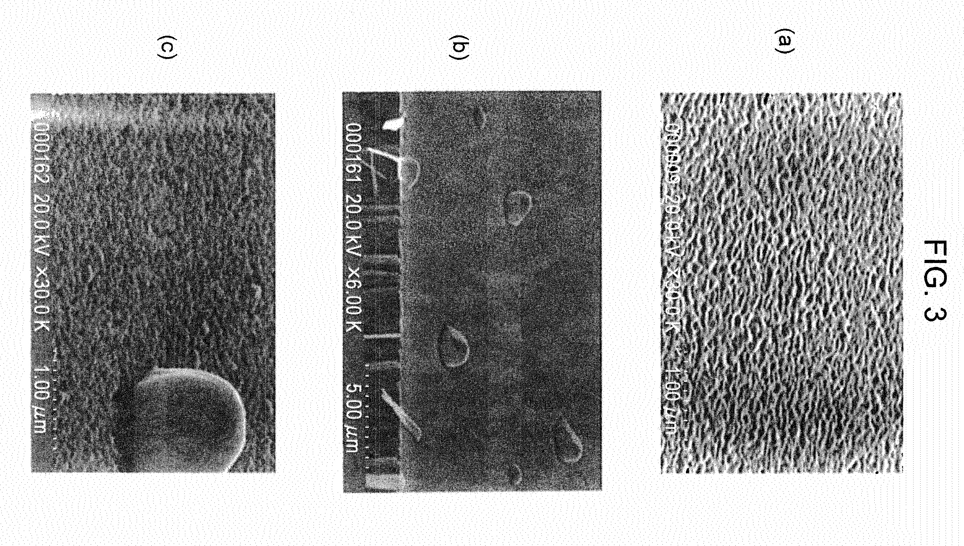

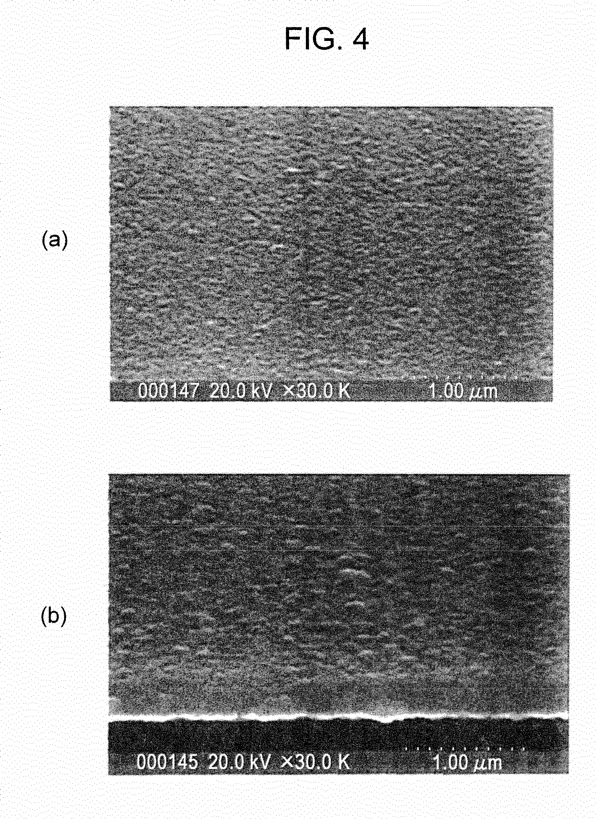

More specifically, various Ag alloy thin films having a thickness of 200 nm shown in Figs. 3(a) to 3(c) and Figs. 4(a) and 4(b) were prepared in the same manner as in Example 1. The content of each element in the Ag alloy thin film was determined in the same manner as in Example 1. For comparison purposes, a pure Ag thin film (Figs. 2(a) to 2(c)) was also prepared in the same manner.

Heat treatment was performed in the air at 400°C for one hour. In heat-assisted magnetic recording, the heating temperature during actual recording is probably in the range of approximately 100°C to 300°C. In the present example, the heating temperature was 400°C for an accelerated test.

These results were shown in Figs. 2(a) to 2(c), Figs. 3(a) to 3(c), and Figs. 4(a) and 4(b).

Figs. 2(a) to 2(c), Figs. 3(a) to 3(c), and Figs. 4(a) and 4(b) show that the film structure of the pure Ag thin film has changed before the aggregation of Ag, and the glass substrate is exposed in the area other than dome-like Ag crystal grains.

In contrast, in a Ag-0.25% by atom Nd alloy thin film (comparative example) containing Nd, the occurrence of dome-like Ag crystal grains is much lower than in the pure Ag thin film, and the Ag-Nd thin film retains smoothness in the area other than the dome-like Ag crystal grains. However, the growth of dome-like crystal grains resulting from the surface diffusion of Ag was not sufficiently prevented. Once the crystal grain growth started, the crystal grains grew to an extent similar to the pure Ag thin film.

In contrast, a Ag-0.07% by atom Bi-0.18% atom Nd alloy thin film (working example) containing Nd and Bi was smooth over the entire surface even after heat treatment, indicating a dramatic decrease in the growth of dome-like crystal grains and excellent heat resistance.

### EXAMPLE 3

In the present example, a Ag-0.14% by atom Bi-0.2% by atom Nd thin film, which satisfied the requirements of the present invention, was used to examine the effects of Ar gas pressure and film thickness during deposition on the surface roughness (Ra).

### Ag Gas Pressure

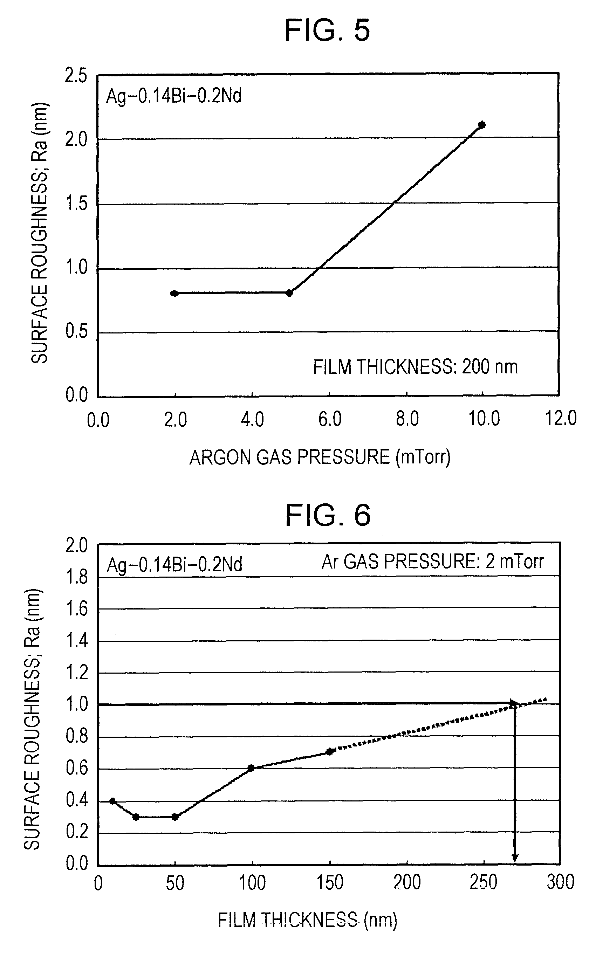

The surface roughness Ra was measured in the same manner as in Example 1 while the Ar gas pressure in Example 1 was changed between 2 and 10 mTorr as illustrated in Fig. 5 (the thickness of a Ag alloy thin film = 200 nm). Fig. 5 shows the results.

Fig. 5 shows that the surface roughness Ra of the Ag alloy thin film markedly increased when the Ar gas pressure exceeded 5 mTorr. This is probably because metal particles sputtered from the target were scattered by Ar. In order to decrease Ra to 1.0 nm or less as specified by the present invention, the Ar gas pressure during deposition is preferably controlled to approximately 6 mTorr or less.

### Film Thickness

The surface roughness Ra was measured in the same manner as in Example 1 while the thickness of a Ag alloy thin film was changed between 10 and 150 nm as illustrated in Fig. 6 by altering the sputtering time in Example 1 (Ar gas pressure = 2 mTorr). Fig. 6 shows the results.

Fig. 6 shows that the surface roughness Ra increased gradually with the thickness of the Ag alloy thin film. Although it is desirable that the thickness of the Ag alloy thin film be increased in terms of thermal diffusion control, the film thickness is preferably controlled to approximately 270 nm or less so as to maintain Ra of 1.0 nm or less as specified by the present invention.

The present application has been described in detail with reference to particular embodiments. It is apparent to a person skilled in the art that various alterations and modifications may be made to the embodiments without departing from the spirit and scope of the present invention.

The present application is based on Japanese Patent Application (Japanese Patent Application No. 2009-262908) filed on November 18, 2009, which is incorporated herein by reference.

### Industrial Applicability

The present invention can provide a Ag alloy thermal diffusion control film in which the composition of Ag alloy is appropriately controlled to maintain high thermal conductivity of Ag and enhance the thermal diffusivity, surface smoothness, and heat resistance of the Ag alloy thermal diffusion control film. Thus, the thermal diffusion control film can be suitably used in magnetic recording media for heat-assisted magnetic recording.

## Claims

1. A Ag alloy thermal diffusion control film for use in a magnetic recording medium for heat-assisted magnetic recording, wherein the thermal diffusion control film contains a Ag alloy mainly composed of Ag and has a surface roughness Ra of 1.0 nm or less, a thermal conductivity of 100 W/(m·K) or more, and a thermal diffusivity of 4.0 x 10⁻⁵ m²/s or more.

2. The Ag alloy thermal diffusion control film according to Claim 1, wherein the Ag alloy contains 0.05% to 0.8% by atom of at least one of Nd and Y and 0.05% to 0.5% by atom of Bi.

3. The Ag alloy thermal diffusion control film according to Claim 2, wherein the Ag alloy further contains 0.2% to 1.0% by atom of Cu.

4. A magnetic recording medium for heat-assisted magnetic recording, comprising the Ag alloy thermal diffusion control film according to any one of Claims 1 to 3.

5. A sputtering target for use in the manufacture of the Ag alloy thermal diffusion control film according to any one of Claims 1 to 3, wherein the sputtering target is made of a Ag alloy that contains 0.05% to 0.8% by atom of at least one of Nd and Y and 0.05% to 0.5% by atom of Bi.

6. The sputtering target according to Claim 5, wherein the Ag alloy further contains 0.2% to 1.0% by atom of Cu.
